(19) Europäisches Patentamt
European Patent Office
Office européen des brevets

(11) **EP 2 157 402 B1**

(12) **FASCICULE DE BREVET EUROPEEN**

(45) Date de publication et mention
de la délivrance du brevet:
**26.12.2012 Bulletin 2012/52**

(51) Int Cl.:
***B81C 3/00*** *(2006.01)*   ***G01B 21/08*** *(2006.01)*
***G01B 21/16*** *(2006.01)*   ***H01L 21/67*** *(2006.01)*

(21) Numéro de dépôt: **09164141.5**

(22) Date de dépôt: **30.06.2009**

(54) **Dispositif de mesure d'alignement de structures accolees**

Vorrichtung zur Messung der Ausrichtung von zusammengefügten Strukturen

Device for measuring the alignment of attached structures

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **22.08.2008 FR 0804677**

(43) Date de publication de la demande:
**24.02.2010 Bulletin 2010/08**

(73) Titulaire: **Commissariat à l'Énergie Atomique et aux Énergies Alternatives**
**75015 Paris (FR)**

(72) Inventeur: **De Crecy, François**
**38180, SEYSSINS (FR)**

(74) Mandataire: **Guérin, Michel et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**WO-A-02/069393**

• **A. PETROPOULOS, G. KALTSAS, D. GOUSTOURIDIS: "A novel system for displacement sensing, integrated on a plastic substrate" MICROELECTRONICS JOURNAL, 19 juin 2008 (2008-06-19), pages 1-6, XP002509401 DOI: 10.1016/j.mejo.2008.04.015**
• **MARK A LANTZ ET AL: "A micromechanical thermal displacement sensor with nanometre resolution; A micromechanical thermal displacement sensor with nanometre resolution" NANOTECHNOLOGY, IOP, BRISTOL, GB, vol. 16, no. 8, 1 août 2005 (2005-08-01), pages 1089-1094, XP020091177 ISSN: 0957-4484**
• **STEEN ET AL: "Overlay as the key to drive wafer scale 3D integration" MICROELECTRONIC ENGINEERING, ELSEVIER PUBLISHERS BV., AMSTERDAM, NL, vol. 84, no. 5-8, 6 mai 2007 (2007-05-06), pages 1412-1415, XP022062027 ISSN: 0167-9317**

**Description**

L'invention concerne le domaine des micro et nanotechnologies, c'est-à-dire le domaine des structures micro-usinées sur des puces fabriquées collectivement sur des tranches planes qui sont découpées ensuite en puces individuelles à la fin du procédé de fabrication collective.

Les structures micro-usinées utilisent les techniques de dépôt, gravures, implantations ioniques, etc. mises au point dans le domaine des circuits intégrés électroniques puis étendues à d'autres domaines. L'échelle des éléments micro-usinés peut descendre au-dessous, voire même largement au-dessous, du micromètre. Ces structures sont soit purement électroniques (circuits électroniques intégrés) soit mixtes, impliquant par exemple des éléments optiques (capteurs d'image, afficheurs, modulateurs optiques par exemple) ou mécaniques (accéléromètres, capteurs de pression, par exemple), ou même chimiques (capteurs chimiques) ou biologiques (bio-capteurs).

Ces structures sont réalisées collectivement sur des tranches de support planes (en anglais "wafer") qui sont le plus souvent en silicium lorsque les structures comportent des éléments électroniques.

Lors de cette fabrication, on peut être amené à exécuter des étapes d'alignement très précis entre deux structures, par exemple en vue d'un collage précis d'une puce individuelle (déjà découpée) sur une tranche, ou encore en vue du collage de deux tranches l'une sur l'autre, avec des éléments de la première tranche placés très précisément en regard d'éléments de la deuxième tranche. C'est typiquement le cas lorsqu'on veut interconnecter plusieurs puces en les collant sur une tranche qui porte des conducteurs d'interconnexion. Il faut dans ce cas que les contacts de la puce soient précisément alignés sur des plots de contact correspondants de la tranche.

En général, l'alignement de la puce sur la tranche ou l'alignement de la première tranche sur la deuxième tranche est mesuré par des méthodes optiques, souvent en infrarouge (pour lequel le silicium est transparent) parce qu'on peut avoir besoin de mesurer un alignement à travers l'épaisseur de la puce ou de la tranche. On utilise des marques d'alignement optiques formées sur les deux pièces à coller. Ces mesures permettent soit de mettre en place les pièces pendant la fabrication soit de contrôler par une mesure le degré de désalignement éventuel après fabrication.

Parfois, l'alignement est facilité en creusant des tranchées profondes dans le silicium à l'endroit des marques d'alignement, afin que les rayons lumineux permettant le contrôle de l'alignement traversent plus facilement l'épaisseur de la puce ou de la tranche.

Pour des mesures de désalignement destructives, on peut utiliser des microscopes électroniques et observer les structures coupées (donc détruites).

On a pu envisager aussi d'effectuer un alignement mécanique par emboîtement de motifs mâles et femelles usinés ou photolithographiés sur les pièces à mettre en regard, mais cela ne permet pas de faire des mesures de qualité d'alignement.

On a imaginé aussi un alignement de pièces par des moyens magnétiques, à savoir des micro-domaines magnétiques déposés sur chacune des pièces et qui s'attirent mutuellement lors de la mise en place des pièces pour favoriser un alignement bien défini. Là encore, il n'y a pas de mesure possible.

Les méthodes de mesure optiques restent les plus efficaces mais souffrent d'inconvénients, en particulier celui de la transparence insuffisante du substrat lorsque l'alignement exige de voir à travers un substrat. Si le substrat est en silicium, on a l'obligation d'utiliser un rayonnement infrarouge pour que le rayonnement le traverse, et la précision d'alignement ne peut guère descendre en dessous de la demi-longueur d'onde du rayonnement utilisé. Même avec un rayonnement infrarouge il faut encore que le silicium ne soit pas trop dopé, le dopage réduisant sa transparence, et il faut éviter qu'il y ait des couches métalliques d'interconnexion au voisinage des marques d'alignement. Ces marques consomment de la place. De plus, il est nécessaire que la couche de colle interposée entre la puce et la tranche ou entre deux tranches soit elle-même transparente à l'infrarouge.

De tels problèmes sont décrits dans l'article "Overlay as the key to drive waferscale 3D intégration" de S.E. Steen et al ; Microelectronic Engineering 84, (2007) p.1412-1415.

Pour mesurer la qualité de l'alignement de deux structures planes solidaires accolées, l'invention propose une méthode originale. Elle consiste à prévoir un élément chauffant sur la surface de l'une des structures et un réseau d'éléments sensibles à la température sur la surface de la deuxième structure ; la forme, l'orientation et la position de l'élément chauffant par rapport à la première structure sont connues ; la forme, l'orientation, et la position de chaque élément sensible individuel par rapport à la deuxième structure sont également connues ; un circuit de mesure et de calcul relié aux éléments sensibles évalue la position d'une structure par rapport à l'autre en fonction des réponses de chacun des éléments sensibles individuels aux variations de température engendrées par l'élément chauffant lorsque les deux structures sont appliquées l'une contre l'autre, l'élément chauffant étant en regard du réseau d'éléments sensibles. Les réponses des éléments sensibles permettent en effet d'établir un profil de distribution de température à partir duquel on peut rechercher un maximum de température ; la position de ce maximum dans le réseau d'éléments sensibles fournit une indication sur la position de l'élément chauffant par rapport aux éléments sensibles, donc sur la position de la première structure par rapport à la deuxième structure.

Une méthode pour détecter des déplacements est décrite dans l'article "A novel system for displacement sensing, integrated on a plastic substrate", de A. Petropoulos et al.; Microelectronics Journal, Vol. 40, N°9, p. 1387-1392 ; en ligne le 9.6.2008.

On propose donc selon l'invention un dispositif comportant deux structures solidaires planes accolées face contre face, caractérisé en ce que la première structure comporte, sur sa face en regard de la deuxième structure, un élément chauffant dont la forme, l'orientation et la position sont connues, en ce que la deuxième structure comporte, sur sa face en regard de la première structure, un réseau d'éléments sensibles à la température dont la forme, l'orientation, et la position par rapport à la deuxième structure sont également connues, le dispositif comportant également un moyen d'alimentation électrique de l'élément chauffant de la première structure et un moyen pour établir des mesures électriques représentant la distribution de températures dans le réseau d'éléments sensibles de la deuxième structure, en vue de déduire de cette distribution une mesure d'alignement relatif des structures accolées.

Le procédé de mesure de la qualité de l'alignement de deux structures accolées face contre face est caractérisé par les opérations suivantes :

- activation d'un élément chauffant placé à une position connue à la surface de la première structure,
- génération de signaux électroniques représentatifs d'une distribution de températures, à partir un réseau d'éléments sensibles à la température placés à des positions connues à la surface de la deuxième structure,
- détermination d'une position relative de l'élément chauffant par rapport au réseau d'éléments sensibles, à partir de la distribution de températures, dans un circuit de calcul recevant les signaux électroniques engendrés dans le réseau d'éléments sensibles.

La détermination de position relative comporte de préférence la recherche d'une courbe théorique de distribution de températures qui correspond de manière optimale à une distribution de températures obtenue à partir des signaux électroniques représentatifs de la température, et le calcul de la position, référencée par rapport au réseau d'éléments sensibles, d'un pic de cette courbe. Ce calcul de position se fera de préférence de la manière suivante : calcul de plusieurs courbes théoriques en fonction d'un paramètre $x_0$ qui est une position possible de l'élément chauffant par rapport au réseau d'éléments sensibles, détermination pour chaque courbe théorique d'une somme, éventuellement pondérée, de carrés d'écarts entre les valeurs de la courbe théorique et les valeurs mesurées, sélection de la courbe théorique qui donne la plus faible valeur de somme de carrés, la valeur $x_{opt}$ du paramètre $x_0$ correspondant à la courbe sélectionnée étant la mesure d'alignement recherchée.

Dans une réalisation destinée à la mesure de l'alignement dans une direction X, parallèle aux surfaces des structures, les éléments sensibles ont une forme de barreaux parallèles allongés dans une direction Y du plan de la surface, perpendiculaire à la direction X, et l'élément chauffant a une forme de barreau parallèle à la direction Y, plus grand, dans la direction Y, que les éléments sensibles.

Les barreaux sont de préférence étroits dans la direction X et allongés dans la direction Y. Ils sont rapprochés, le pas des barreaux étant lié à la précision de mesure désirée. L'élément chauffant a de préférence une longueur plus grande, dans la direction X, que les éléments sensibles.

On peut interposer entre les éléments sensibles proprement dits et l'élément chauffant, une ou plusieurs couches de matériau organisées pour établir dans le réseau une conductivité thermique anisotrope, plus élevée dans la direction perpendiculaire aux surfaces, moins élevée dans au moins une des directions X et Y parallèles à la surface. Ces couches peuvent être placées sur l'une ou l'autre des deux structures. De préférence, ces couches sont réalisées dans un matériau thermiquement bon conducteur, subdivisé en éléments séparés les uns des autres dans la direction X (cette direction étant celle dans laquelle on cherche à mesurer la qualité d'alignement). La forme des portions de couches thermiquement conductrices peut être en barreaux, comme les éléments sensibles à la température ; les barreaux sont alors espacés dans la direction X. La forme des éléments thermiquement conducteurs peut aussi être en plots espacés les uns des autres à la fois dans la direction X et dans la direction Y.

Le calcul d'alignement est de préférence fait par un processeur extérieur aux structures accolées. Le moyen de calcul (en pratique un microprocesseur programmé) effectue la détermination de la position $x_{opt}$, référencée par rapport au réseau d'éléments sensibles, du pic d'une courbe théorique de distribution de températures correspondant le mieux possible à la distribution de valeurs représentatives de la température mesurées par le réseau d'éléments sensibles.

D'autres caractéristiques et avantages de l'invention apparaîtront à la lecture de la description détaillée qui suit et qui est faite en référence aux dessins annexés dans lesquels:

- la figure 1 représente un schéma de principe de l'invention ;
- la figure 2 représente de manière plus détaillée un exemple d'organisation de l'élément chauffant et des éléments sensibles à la température ;
- la figure 3 représente un exemple théorique de profil de température engendrées au-dessous de l'élément chauffant ;
- la figure 4 représente un exemple de mesures de température faites par le réseau d'éléments sensibles, et un profil théorique de distribution de températures correspondant au mieux aux mesures effectuées ;

- la figure 5 représente un exemple de mise en oeuvre de l'invention avec une interposition de barreaux parallèles thermiquement conducteurs, entre l'élément chauffant et le réseau d'éléments sensibles à la température.

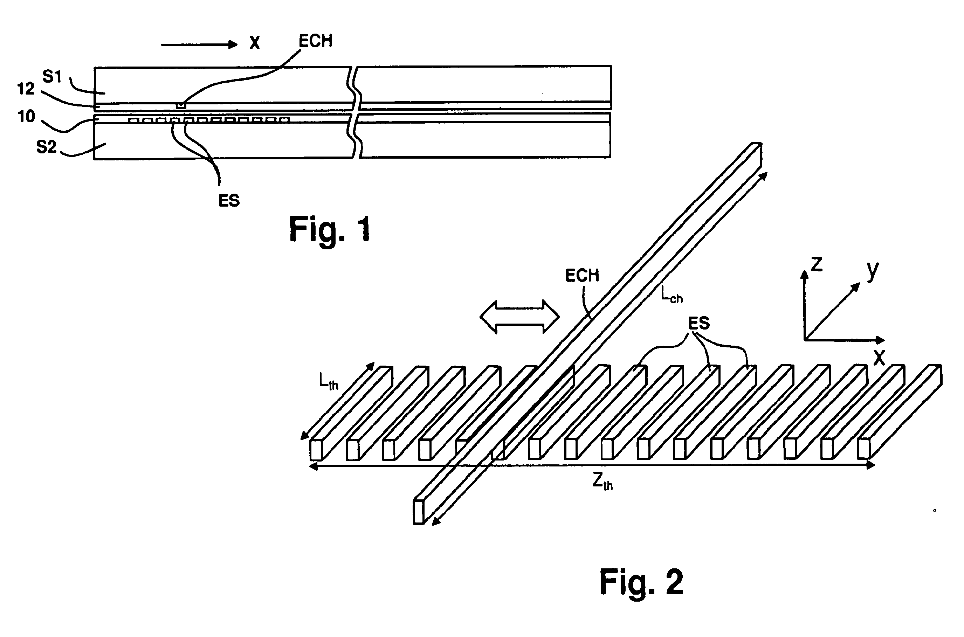

La figure 1 résume le principe de l'invention. Deux structures (ou objets) désignées par S1 et S2 sont placées face à face, dans le but d'être collées l'une sur l'autre avec un alignement précis des structures l'une par rapport à l'autre dans une direction X parallèle aux surfaces en regard. Les structures sont par exemple des tranches semiconductrices ou encore une puce et une tranche, mais ce pourraient être d'autres types de structures quelconques ayant chacune une face plane et destinées à être collées avec leurs faces planes en regard. Les structures sont des structures micro-usinées, électroniques ou mixtes (mécanique et électronique par exemple). Elles sont réalisées par photogravures, dépôts, implantations, pour réaliser des éléments non représentés correspondant aux fonctionnalités désirées pour l'ensemble des deux structures collées. L'une des structures peut comprendre par exemple des interconnexions électriquement conductrices et des plages de contact destinées à être mises en contact direct avec des plages de contact correspondantes formées sur l'autres structure.

Les structures S1 et S2 sont vues en coupe dans un plan perpendiculaire à leurs surfaces en regard ; elles sont représentées séparées mais elles sont destinées à être collées, avec ou sans matière de collage.

Les structures sont munies de moyens de détermination de la qualité d'alignement dans la direction X parallèle aux surfaces en vis-à-vis. On comprendra que d'autres moyens, séparés des premiers, peuvent être prévus pour mesurer l'alignement dans une direction perpendiculaire à la direction X et parallèle aux surfaces en regard.

Les moyens de détermination de la qualité d'alignement comprennent un élément chauffant ECH formé sur la surface de la première structure S1, plus précisément sur la face tournée vers l'autre structure S2. Ils comprennent par ailleurs un réseau d'éléments sensibles à la température ES formés sur la surface de la deuxième structure, en regard de la première structure.

L'élément chauffant ECH a une forme, une orientation, et une position connues par rapport à la première structure S1. De même les éléments sensibles à la température ES ont des formes positions et orientations connues par rapport à la deuxième structure S2. Les positions de l'élément chauffant ECH et des éléments sensibles ES sur la structure respective dont ils font partie sont telles que l'élément chauffant est en regard d'une position de référence bien déterminée dans le réseau d'éléments sensibles lorsque les structures sont correctement alignées. De préférence, la position de référence est une position centrale du réseau d'éléments sensibles.

La détermination de l'alignement des structures passe par une détection de la position de l'élément chauffant par rapport à la position de référence dans le réseau d'éléments sensibles. Un écart de position dans un sens ou dans l'autre est une indication d'erreur d'alignement.

Selon l'invention, on recherche à l'aide des éléments sensibles à la température un profil de température dans le réseau de la deuxième structure et on extrait de ce profil une information sur la position la plus probable de l'élément chauffant par rapport au réseau d'éléments sensibles. L'écart de position de l'élément chauffant par rapport à la position de référence représente l'erreur d'alignement.

L'erreur d'alignement est mesurée a posteriori une fois que les structures sont collées.

On a dit ci-dessus que l'élément chauffant est réalisé sur la surface de la première structure et les éléments sensibles à la température sont réalisés sur la surface en regard de la deuxième structure. On comprendra que ces éléments sont réalisés selon des technologies de microélectronique qui peuvent exiger qu'il y ait des dépôts de couches supplémentaires entre les éléments et la surface extérieure des structures, typiquement des couches de passivation telles que les couches 10 et 12, respectivement sur la première et la deuxième structure, qui protègent les éléments des agressions extérieures.

Sur la figure 2, on a représenté une possibilité de réalisation géométrique de l'élément chauffant et des éléments sensibles à la température. Seuls ces éléments sont représentés sur la figure 2. L'élément chauffant est un barreau résistif allongé dans une direction Y perpendiculaire à la direction X selon laquelle on veut mesurer l'erreur d'alignement. Les directions X et Y sont parallèles à la surface des structures ; la direction Z est perpendiculaire à ces surfaces. Les éléments sensibles à la température ES sont des barreaux résistifs, mais dont la résistance varie fortement avec la température. Ils sont allongés dans la même direction Y que l'élément chauffant ECH. Les barreaux ES sont étroits et rapprochés. Ils sont de préférence régulièrement espacés dans la direction X. La longueur $L_{ch}$ du barreau chauffant ECH est de préférence largement supérieure à la longueur $L_{th}$ des barreaux sensibles. Les barreaux sensibles ES sont répartis sur une longueur $X_{th}$ dans la direction X. Le pas de répartition est $X_{th}/N$ s'il y a N éléments. En supposant que la position de référence du barreau ECH est au milieu du réseau d'éléments sensibles ES, l'erreur d'alignement maximale détectable est de $X_{th}/2$ dans un sens ou dans l'autre et la précision de détection est meilleure que $X_{th}/N$.

L'élément chauffant est relié, pour la mesure d'alignement, à une source d'énergie non représentée, en courant ou en tension, qui induit un effet thermique (effet Joule ou autre). Les éléments sensibles à la température sont reliés aux entrées multiples d'un circuit de mesure (non représenté) apte à détecter des variations de résistance des éléments, induites par des variations de température de l'élément. Typiquement, si l'élément est une résistance de résistivité variable avec la température, le circuit de mesure peut comprendre, pour chaque élément, une source de courant constant alimentant cette résistance et un amplificateur de mesure de la tension aux bornes de la résistance. Les différentes tensions issues des éléments sensibles à la température sont recueillies pour être traitées, de préférence après conversion analogique-numérique, par un circuit de calcul qui va déduire une erreur d'alignement éventuelle. Le circuit de calcul peut être extérieur aux deux structures et dans ce cas la deuxième structure doit posséder des plots de connexion extérieure pour transmettre des mesures au circuit de calcul.

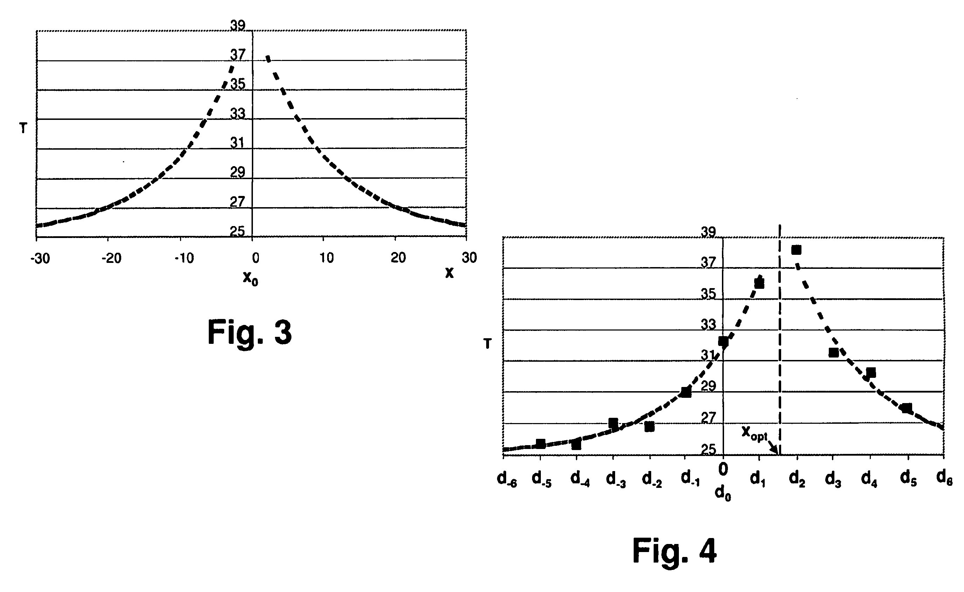

La figure 3 représente une courbe de simulation numérique, représentant en ordonnée une température induite par l'élément chauffant activé par une source d'énergie, avec en abscisse, en unités arbitraires, l'éloignement dans un sens ou dans l'autre par rapport à l'élément chauffant supposé placé à l'abscisse $x_0$. La température peut être graduée en unités arbitraires, mais, pour la compréhension, on a supposé que la température varie de 25° (supposée être la température ambiante des structures) à 39° représentant sensiblement la température atteinte au voisinage de la surface de la deuxième structure, précisément en regard de l'élément chauffant. La décroissance de la température suit une loi plus ou moins exponentielle en fonction de la distance latérale par rapport à la position $x_0$ de l'élément chauffant (à hauteur constante au-dessous de ce dernier).

On peut considérer que la température suit ce genre de loi d'une manière indépendante de la position selon la direction Y, pourvu qu'elle soit prise vers le milieu des barreaux de la figure 2 et que les barreaux soient suffisamment longs (surtout le barreau constituant l'élément chauffant) pour éviter des effets de bords. On suppose aussi, pour tracer ces courbes, que le substrat constitue une sorte de source froide vis-à-vis du réseau d'éléments sensibles, c'est-à-dire que la température de la structure ne monte pas globalement du fait de l'activation de l'élément chauffant.

On estime que le profil de température dans le plan médian du réseau d'éléments sensibles (là où les effets de bords ne se font pas sentir) peut être représenté approximativement par une équation telle que :

$$T(x) = T_o + T_1 \cdot \exp\left(\frac{-|x - x_o|}{L_{ref}}\right) \qquad \text{(équation 1)}$$

où x est l'abscisse d'une position sur l'axe X, $x_0$ est l'abscisse d'une position de référence qui est à la verticale du centre de l'élément chauffant, T(x) est la température à la surface de la deuxième structure à la position x, $T_0$ et $T_1$ sont des constantes (homogènes à des températures), et $L_{ref}$ est une longueur de référence représentant en quelque sorte une longueur de diffusion de la chaleur dans la direction horizontale.

Cette équation est une approximation mathématique du phénomène physique de diffusion de la chaleur à partir de l'élément chauffant. De manière générale, on peut dire qu'en principe la courbe sera symétrique par rapport à une position $x_0$ qui représente le centre de symétrie, sur l'axe X, de l'élément chauffant, typiquement à la moitié de la largeur du barreau lorsque c'est un barreau résistif. On comprendra que cette symétrie peut être imparfaite en raison des configurations de couches à proximité de l'élément chauffant, mais on cherchera à construire ces couches de la manière la plus symétrique possible, aussi bien sur la première structure que sur la deuxième structure pour ne pas induire des dissymétries de répartition de températures qui fausseraient les calculs.

Les deux structures étant collées, on applique à l'élément chauffant la tension qui va le faire chauffer, et on utilise les mesures fournies par les éléments sensibles à la température pour déterminer une série de valeurs de température. On pourrait aussi envisager de le faire pour des structures sur le point d'être collées à condition que les structures puissent être reliées électriquement à l'extérieur à ce stade pour être mises sous tension et pour fournir des signaux électroniques de mesure analogiques ou numériques.

On a représenté sur la figure 4 des exemples de points de mesure qui sont des valeurs de tension ou courant numérisées, qui elles-mêmes représentent des températures détectées par les éléments individuels. Les points sont tracés avec en abscisse la position des éléments sensibles. Une position d'abscisse 0 est prise comme une position de référence au-dessus de laquelle l'élément chauffant devrait être si les structures étaient parfaitement alignées. Cette position peut être par exemple l'abscisse $d_0$ du centre d'un élément sensible central du réseau. Les autres éléments sensibles sont à des positions $d_1$, $d_2$, ..., $d_6$ pour les éléments situés d'un côté et $d_{-1}$, $d_{-2}$, ... de l'autre côté. Les grandeurs en ordonnée peuvent être assimilées à des températures, en unités arbitraire, en supposant que les éléments résistifs fournissent une tension variant proportionnellement à la température (s'ils ne fournissaient pas une mesure proportionnelle il faudrait en tenir compte dans les calculs effectués sur ces mesures).

On constate que les valeurs mesurées sont réparties selon une courbe qui ressemble à celle de la figure 3 mais qui peut être plus ou moins décalée latéralement par rapport à la position centrale en fonction du degré de désalignement des structures. Sur la figure 4, on voit d'une part les points de mesure et d'autre part une courbe de température estimée, suivant la fonction mathématique indiquée plus haut (équation 1) et passant de manière optimale à proximité de ces points de mesure.

Différentes méthodes de calcul connues permettent de déterminer la position de la courbe qui passe le mieux par les points de mesure. Une méthode par régression non-linéaire convient pour cette détermination. La régression utilisant les moindres carrés est la mieux adaptée. Elle consiste typiquement à établir des courbes répondant à l'équation 1 en faisant varier les paramètres $T_0$, $T_1$, $L_{ref}$ et $x_0$, à calculer pour chaque courbe, c'est-à-dire pour chaque groupe de quatre paramètres $T_0$, $T_1$, $L_{ref}$ et $x_0$, et pour chacune des abscisses de mesure connues ($d_{-6}$ à $d_{+6}$ sur la figure 4) le carré de la différence entre la valeur mesurée et la valeur donnée par la courbe pour cette abscisse, à additionner les carrés pour tous les points de mesure pour une courbe donnée, et à rechercher quelle est la combinaison de paramètres $T_0$, $T_1$, $L_{ref}$ et $x_0$, qui minimise la somme des carrés. La méthode peut être affinée en utilisant non pas la différence entre la valeur mesurée et la valeur calculée mais cette différence divisée par l'incertitude estimée sur la valeur mesurée, lorsque l'incertitude estimée n'est pas la même pour tous les points de mesure. La somme des carrés des différences est alors une somme pondérée et la pondération est dans ce cas faite par l'inverse des carrés des incertitudes pour chaque mesure.

La valeur de $x_0$ qui fournit la courbe passant au mieux par les points de mesure est désignée par $x_{opt}$ sur la figure 4. La valeur $x_{opt}$ représente alors l'écart d'alignement entre les deux structures. La précision de la mesure dépend bien entendu de la précision (relative) de mesure des températures et du pas de répartition des éléments sensibles. La précision peut être meilleure que le pas de répartition.

On n'entrera pas dans le détail des technologies utilisables pour réaliser l'élément chauffant et les éléments sensibles à la température. Ces technologies sont très nombreuses et on adaptera la réalisation à la technologie de chacune des structures à aligner. La technologie utilisée pour réaliser les éléments sensibles à la température pourra être différente de la technologie utilisée pour réaliser l'élément chauffant, notamment dans le cas où les deux structures à coller ne sont pas faites dans la même technologie.

A titre d'exemple : l'élément chauffant peut être un élément résistif (par exemple en couche métallique avec un métal suffisamment résistif ou en couche semiconductrice), mais ce peut être aussi le canal d'un transistor. L'élément résistif peut être fait en couche déposée (silicium polycristallin dopé) ou intégrée dans le silicium du substrat grâce à une implantation locale avec un dopant permettant de définir la géométrie et la conductivité de la résistance. Etant donné que la structure qui porte l'élément chauffant porte d'autres dispositifs électroniques non liés à la question de l'alignement, elle sera souvent réalisée avec plusieurs niveaux de dépôts isolants, conducteurs ou semiconducteurs superposés au-dessus du substrat semiconducteur de départ et on aura avantage à réaliser l'élément chauffant dans un des niveaux supérieurs de la structure afin qu'il soit le plus proche possible de la surface en contact avec la deuxième structure. De manière optimale, une simple couche de passivation planarisée recouvre l'élément chauffant.

L'élément chauffant a de préférence une géométrie très allongée, aussi étroite que possible dans la direction X de mesure d'alignement, pour confiner la source de chaleur dans une zone très étroite dans cette direction X.

Les éléments sensibles à la température peuvent être des éléments résistifs de résistivité variable avec la température ou des diodes ou des transistors. Si on utilise des résistances variables, le matériau résistif choisi doit être un matériau dont la résistivité dépend de la température. Les semiconducteurs répondent à ce critère. Une diode présente l'avantage d'être très sensible à la température lorsqu'elle est polarisée en inverse. Le courant dans un transistor faiblement polarisé en direct est également sensible à la température.

Comme pour l'élément chauffant, il est préférable que les éléments sensibles soient aussi proches que possible de la surface extérieure de la structure donc de la surface de l'autre structure qui porte l'élément chauffant. De ce point de vue il est préférable de faire des éléments sensibles par dépôt d'une couche résistive.

Les éléments sensibles à la température doivent être aussi étroits et rapprochés que possible dans la direction X pour obtenir une mesure précise d'alignement. Ils ont une forme allongée dans la direction perpendiculaire Y pour réduire les effets de bord de la diffusion de température. L'allongement est dans une direction parallèle à celle de l'élément chauffant. L'élement chauffant est cependant de préférence plus long que les éléments sensibles (sur la figure 2 : $L_{ch}$ est de préférence supérieur à $5.L_{th}$) ; et il est de préférence plus long que l'étendue, dans la direction X, du réseau d'éléments sensibles (sur la figure 2 : $L_{ch}$ est de préférence supérieur à $Z_{th}$, par exemple deux fois supérieur).

Le nombre d'éléments sensibles dépend de la précision souhaitée ; il est d'au moins 5 et peut être beaucoup plus élevé (plusieurs dizaines à plusieurs centaines, en prenant en compte toutefois le fait qu'en augmentant le nombre on augmente la surface consommée et la puissance de calcul nécessaire pour faire les comparaisons de courbes expliquées ci-dessus.

Il est préférable mais non obligatoire que les éléments sensibles soient répartis avec un pas constant. Il faut en tous cas connaître leur position relative par rapport à l'ensemble de la structure sur laquelle ils sont réalisés. On peut envisager cependant que le pas de répartition soit plus étroit autour de la position idéale désirée, en principe au centre du réseau, et plus large aux extrémités du réseau.

L'étendue du réseau sera choisie en fonction du désalignement maximal qu'on veut pouvoir mesurer. Elle est par exemple deux fois supérieure à la gamme maximale qu'on veut mesurer.

Etant donné que le principe de ce système de mesure repose sur une détection de profil de température engendré localement par un élément chauffant, il est souhaitable qu'un profil de température latéral avec un pic marqué s'établisse sur le réseau d'éléments sensibles. On préfère alors que les éléments sensibles soient noyés dans un environnement dans lequel la conductivité thermique est anisotrope, plus faible dans la direction X que dans la direction Z.

On peut utiliser pour cela une couche organisée de matériau à forte conductivité thermique intercalée entre l'élément chauffant et le réseau d'éléments sensibles (en pratique réalisée sur la deuxième structure au-dessus des éléments sensibles). Le matériau bon conducteur thermique (par exemple un métal) est réparti de préférence régulièrement dans la direction X. De cette manière la dissipation de chaleur est plus facilement concentrée vers les éléments sensibles.

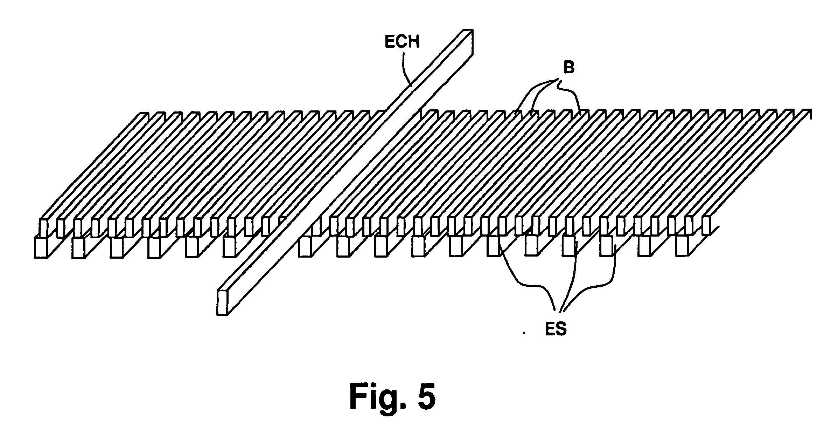

La figure 5 représente une telle structure avec des barreaux thermiquement conducteurs B au-dessus des barreaux résistifs ES sensibles à la température. Dans l'exemple représenté, les barreaux thermiquement conducteurs sont plus nombreux que les barreaux résistifs. Là où ils sont superposés aux barreaux conducteurs, ils peuvent être en contact direct avec ces barreaux, à condition toutefois qu'ils soient par ailleurs isolés électriquement de tout autre conducteur pour ne pas empêcher les éléments résistifs de jouer leur rôle de mesure.

Le matériau conducteur peut typiquement être un matériau métallique qu'on utilise dans les technologies de micro-électronique pour former des vias conducteurs électriques entre deux niveaux d'interconnexion. Le métal peut être du cuivre par exemple.

Plutôt que des barreaux thermiquement conducteurs on peut prévoir des plots conducteurs répartis, mais alors, bien que ce ne soit pas obligatoire, il est préférable que ces plots soient alignés parallèlement aux barreaux résistifs et au-dessus de ceux-ci. Ils peuvent aussi être disposés en quinconce.

Si la structure qui porte les éléments sensibles à la température est réalisée dans une technologie à plusieurs niveaux d'interconnexion séparés par des vias, on peut aussi prévoir que les plots ou barreaux thermiquement conducteurs sont disposés sur plusieurs niveaux superposés, toujours dans le but d'augmenter la conductivité thermique verticale par rapport à la conductivité dans la direction X.

Le dispositif électronique qui exploite la mesure de la température par chaque élément sensible est en principe extérieur aux structures superposées. Au moins un plot de connexion extérieure sur la première structure sert alors à appliquer un courant au dispositif chauffant, et au moins un plot extérieur sur la deuxième structure sert à recueillir un signal électrique représentatif de la température, issu des différents éléments sensibles de la deuxième structure. Pour éviter d'avoir autant de plots que d'éléments sensibles, voire même deux fois plus de plots que d'éléments sensibles, on prévoit de préférence que la deuxième structure comporte des circuits électroniques embarqués permettant d'appliquer simultanément ou successivement un courant ou une tension à chaque élément et de recueillir une information sur la température de chacun d'eux. Un séquenceur de balayage permet par exemple que la mesure soit effectuée successivement sur les différents éléments pour transmettre les mesures successives sur un seul plot de sortie. Etant donné que la mesure de désalignement nécessite des calculs, une conversion analogique-numérique peut être faite dans la première structure pour sortir en série sur un ou plusieurs plots de connexion extérieure une succession de valeurs numériques représentant les différentes températures mesurées. L'exploitation par calcul de ces valeurs numériques, pour trouver la valeur de désalignement $x_{opt}$ est de préférence faite par un microprocesseur programmé extérieur aux deux structures.

Le procédé selon l'invention présente l'avantage d'être non destructif (pour une mesure d'alignement de structures déjà collées) ; le procédé est applicable au collage de puces sur une tranche ou d'une tranche sur une autre tranche ; il n'impose pas les contraintes de transparence qu'exigent les méthodes optiques ; le substrat de chaque structure peut donc être en un matériau quelconque, de même que le matériau de collage s'il y en a. On peut envisager sa mise en oeuvre pour plus de deux structures superposées et contrôler l'alignement indépendamment de chaque structure par rapport à la suivante dans la superposition.

La précision de positionnement peut être inférieure au micromètre. La mesure d'alignement peut servir non seulement à contrôler les pièces produites, mais aussi à calibrer les équipements de collage en mesurant le biais de désalignement qu'ils produisent et en compensant ce biais systématiquement avant de procéder à un collage.

Une manière simple de faire un élément chauffant satisfaisant aux besoins est de le réaliser sous forme d'un transistor dont la longueur de canal est orientée dans la direction X et est assez courte, par exemple celle de la technologie mise en oeuvre dans la 1ère structure, mais dont la largeur de canal dans la direction Y est beaucoup plus grande et nettement supérieure au désalignement maximum envisageable. L'avantage d'un tel mode de réalisation est qu'il est bien connu et bien maîtrisé par l'homme de l'art, facile à intégrer dans un processus de fabrication classique destiné à un circuit intégrant du CMOS. On peut de plus générer des densités linéiques de puissance (par unité de largeur du transistor) assez élevées. Le problème de l'amenée de courant à la source et au drain peut être aisément résolu avec des interconnections en cuivre qui sont principalement orientées suivant la direction Y.

Une manière préféré de réaliser les éléments sensibles est de les faire dans les niveaux d'interconnexion les plus élevés possibles, sous forme de résistance en polysilicium dopé. L'homme de l'art sait réaliser ces résistances par des procédés classiques de microélectronique (dépôts, implantation et diffusion d'impuretés, photolithographie, etc.). Il est préférable qu'elles soient les plus étroites possibles dans la direction X. La dimension dans la direction Y résultera du compromis suivant: elle doit être à la fois nettement plus petite que la dimension suivant Y du transistor pour rester dans la zone où le champ de température est principalement bidimensionnel et être à la fois suffisamment grande dans la direction Y pour avoir une résistance suffisamment élevée et donc facilement mesurable car nettement plus grande que la résistance des lignes d'amenée de courant. Un des avantages de ce mode de réalisation est que les résistances en polysilicium ont une assez forte variation de résistance en fonction de la température. Un autre avantage est que l'homme de l'art sait facilement ajuster le dopage pour obtenir la valeur de la résistance qu'il souhaite: cette valeur doit de préférence être assez grande devant la résistance des amenées de courant. Un autre avantage encore est qu'on peut faire ces résistances en polysilicium dans les niveaux supérieurs d'interconnexions, proche de l'interface de collage.

**Revendications**

1. Dispositif comportant deux structures (S1, S2) planes solidaires, accolées face contre face, **caractérisé en ce que** la première structure (S1) comporte, sur sa face en regard de la deuxième structure, un élément chauffant (ECH) dont la forme, l'orientation et la position sont connues, **en ce que** la deuxième structure (S2) comporte, sur sa face en regard de la première structure, un réseau d'éléments (ES) sensibles à la température dont la forme, l'orientation, et la position par rapport à la deuxième structure sont également connues, le dispositif comportant également un moyen d'alimentation électrique de l'élément chauffant de la première structure et un moyen pour établir des mesures électriques représentant la distribution de températures dans le réseau en vue de déduire de cette distribution une mesure d'alignement relatif des structures accolées.

2. Dispositif selon la revendication 1, **caractérisé en ce que** les éléments sensibles ont une forme de barreaux parallèles allongés dans une direction Y du plan de la surface, perpendiculaire à une direction X dans laquelle on souhaite mesurer l'alignement, et l'élément chauffant a une forme de barreau parallèle à la direction Y.

3. Dispositif selon la revendication 2, **caractérisé en ce que** les éléments sensibles sont constitués dans un matériau dont la résistivité varie avec la température.

4. Dispositif selon l'une des revendications 1 à 3, **caractérisé en ce qu'**il comporte, interposée entre les éléments sensibles et l'élément chauffant, au moins une couche organisée pour établir dans le réseau une conductivité thermique anisotrope, plus élevée dans la direction Z perpendiculaire aux faces en regard, moins élevée dans au moins une direction X ou Y, parallèle aux faces en regard, dans laquelle on souhaite mesurer l'alignement.

5. Dispositif selon la revendication 4, **caractérisé en ce que** la couche établissant une conductivité thermique anisotrope comprend des éléments en forme de barreaux parallèles en un matériau à forte conductivité thermique, espacés les uns des autres.

6. Dispositif selon la revendication 4, **caractérisé en ce que** la couche établissant une conductivité thermique anisotrope comprend des éléments en forme de plots en un matériau à forte conductivité thermique, espacés les uns des autres.

7. Dispositif selon l'une des revendications précédentes, **caractérisé en ce qu'**il comporte, de préférence à l'extérieur des structures accolées, un moyen de calcul apte à effectuer la détermination de la position $x_{opt}$, référencée par rapport au réseau d'éléments sensibles, du pic d'une courbe théorique de distribution de températures correspondant le mieux à la distribution de valeurs représentatives de la température mesurées par le réseau d'éléments sensibles.

8. Procédé de mesure de l'alignement relatif de deux structures planes, accolées face contre face et solidaires, **caractérisé par** les opérations suivantes :

   - activation d'un élément chauffant (ECH) placé à un position connue à la surface d'une première structure (S1),
   - génération de signaux électroniques représentatifs d'une distribution de températures, à partir un réseau d'éléments (ES) sensibles à la température placés à des positions connues à la surface de la deuxième structure (S2),
   - détermination d'une position relative de l'élément chauffant par rapport au réseau d'éléments sensibles, à partir de la distribution de températures, dans un circuit de calcul recevant les signaux électroniques engendrés dans le réseau d'éléments sensibles.

9. Procédé selon la revendication 8, **caractérisé en ce que** la détermination de position relative comporte le calcul de la position, référencée par rapport au réseau d'éléments sensibles, d'un pic d'une courbe théorique de distribution de températures qui correspond de manière optimale à une distribution de températures obtenue à partir des signaux électroniques représentatifs de la température.

**10.** Procédé selon la revendication 9, **caractérisé en ce que** le calcul de position comporte le calcul de plusieurs courbes théoriques en fonction d'un paramètre $x_0$ qui est une position possible de l'élément chauffant par rapport au réseau d'éléments sensibles, une détermination de somme, éventuellement pondérée, de carrés d'écarts entre les valeurs de la courbe théorique et les valeurs mesurées, une sélection de la courbe qui donne la plus faible valeur de somme de carrés, la valeur $x_{opt}$ du paramètre $x_0$ correspondant à cette courbe étant la mesure d'alignement recherchée.

**Claims**

**1.** Device comprising two plane structures (S1, S2), adjoining face to face and fastened together, **characterized in that** the first structure (S1) comprises, on its face opposite the second structure, a heating element (ECH) whose form, orientation and position are known, **in that** the second structure (S2) comprises, on its face opposite the first structure, an array of temperature sensitive elements (ES) whose form, orientation and position with respect to the second structure are also known, the device also comprising an electrical power supply means for the heating element of the first structure and a means for establishing electrical measurements representing the distribution of temperatures in the array with a view to deducing from this distribution a measurement of relative alignment of the adjoining structures.

**2.** Device according to Claim 1, **characterized in that** the sensitive elements have a form of parallel bars elongated in a direction Y of the plane of the surface, perpendicular to a direction X in which it is desired to measure the alignment, and the heating element has a bar form parallel to the direction Y.

**3.** Device according to Claim 2, **characterized in that** the sensitive elements are constituted in a material whose resistivity varies with temperature.

**4.** Device according to one of Claims 1 to 3, **characterized in that** it comprises, interposed between the sensitive elements and the heating element, at least one layer organized so as to establish in the array an anisotropic thermal conductivity, higher in the direction Z perpendicular to the opposite faces, lower in at least one direction X or Y, parallel to the opposite faces, in which it is desired to measure the alignment.

**5.** Device according to Claim 4, **characterized in that** the layer establishing an anisotropic thermal conductivity comprises elements in the form of parallel bars of a material with high thermal conductivity, spaced apart.

**6.** Device according to Claim 4, **characterized in that** the layer establishing an anisotropic thermal conductivity comprises elements in the form of tags of a material with high thermal conductivity, spaced apart.

**7.** Device according to one of the preceding claims, **characterized in that** it comprises, preferably external to the adjoining structures, a calculation means able to perform the determination of the position $x_{opt}$, referenced with respect to the array of sensitive elements, of the peak of a theoretical curve of temperature distribution corresponding best to the distribution of values representative of the temperature measured by the array of sensitive elements.

**8.** Method for measuring the relative alignment of two plane structures, adjoining face to face and fastened together, **characterized by** the following operations:

- activation of a heating element (ECH) placed at a known position on the surface of a first structure (S1),
- generation of electronic signals representative of a distribution of temperatures, on the basis of an array of temperature sensitive elements (ES) placed at known positions on the surface of the second structure (S2),
- determination of a relative position of the heating element with respect to the array of sensitive elements, on the basis of the distribution of temperatures, in a calculation circuit receiving the electronic signals engendered in the array of sensitive elements.

**9.** Method according to Claim 8, **characterized in that** the relative position determination comprises the calculation of the position, referenced with respect to the array of sensitive elements, of a peak of a theoretical curve of temperature distribution which corresponds in an optimal manner to a temperature distribution obtained on the basis of the electronic signals representative of the temperature.

10. Method according to Claim 9, **characterized in that** the position calculation comprises the calculation of several theoretical curves as a function of a parameter $x_0$ which is a possible position of the heating element with respect to the array of sensitive elements, a determination of a sum, optionally weighted, of squares of deviations between the values of the theoretical curve and the measured values, a selection of the curve which gives the lowest value of sum of squares, the value $x_{opt}$ of the parameter $x_0$ corresponding to this curve being the alignment measurement sought.

**Patentansprüche**

1. Vorrichtung, die zwei verbundene ebene, Seite an Seite zusammengefügte Strukturen (S1, S2) aufweist, **dadurch gekennzeichnet, dass** die erste Struktur (S1) auf ihrer Seite, die der zweiten Struktur gegenüberliegt, ein Heizelement (ECH) aufweist, dessen Form, Ausrichtung und Position bekannt sind, dass die zweite Struktur (S2) auf ihrer Seite, die der ersten Struktur gegenüberliegt, ein Netzwerk temperaturempfindlicher Elemente (ES) aufweist, deren Form, Ausrichtung und Position im Verhältnis zur zweiten Struktur ebenfalls bekannt sind, wobei die Vorrichtung ebenfalls ein Mittel zur elektrischen Versorgung des Heizelements der ersten Struktur und ein Mittel umfasst, um elektrische Messungen durchzuführen, die die Temperaturverteilung in dem Netzwerk darstellen, um aus dieser Verteilung eine Messung der relativen Ausrichtung der zusammengefügten Strukturen abzuleiten.

2. Vorrichtung nach Anspruch 1, **dadurch gekennzeichnet, dass** die empfindlichen Elemente eine Form paralleler Stäbe haben, die in eine Richtung Y der Oberflächenebene senkrecht zu einer Richtung X, in der die Ausrichtung gemessen werden soll, ausgestreckt sind, und das Heizelement eine Form eines zur Richtung Y parallelen Stabs hat.

3. Vorrichtung nach Anspruch 2, **dadurch gekennzeichnet, dass** die empfindlichen Elemente aus einem Material bestehen, dessen Leitungswiderstand mit der Temperatur schwankt.

4. Vorrichtung nach einem der Ansprüche 1 bis 3, **dadurch gekennzeichnet, dass** sie zwischen den empfindlichen Elementen und dem Heizelement mindestens eine Schicht aufweist, die organisiert ist, um in dem Netzwerk eine in der Richtung Z senkrecht zu den gegenüberliegenden Seiten höhere und in mindestens einer zu den gegenüberliegenden Seiten parallelen Richtung X oder Y, in der die Ausrichtung gemessen werden soll, niedrigere ansisotrope thermische Leitfähigkeit herzustellen.

5. Vorrichtung nach Anspruch 4, **dadurch gekennzeichnet, dass** die Schicht, die eine anisotrope thermische Leitfähigkeit herstellt, Elemente in Form von parallelen Stäben aus einem Material mit starker thermischer Leitfähigkeit umfasst, die voneinander beabstandet sind.

6. Vorrichtung nach Anspruch 4, **dadurch gekennzeichnet, dass** die Schicht, die eine anisotrope thermische Leitfähigkeit herstellt, Elemente in Form von Stiften aus einem Material mit starker thermischer Leitfähigkeit umfasst, die voneinander beabstandet sind.

7. Vorrichtung nach einem der vorangehenden Ansprüche, **dadurch gekennzeichnet, dass** sie vorzugsweise außerhalb der zusammengefügten Strukturen ein Rechenmittel umfasst, das imstande ist, die Bestimmung der Position $x_{opt}$, die im Verhältnis zum Netzwerk empfindlicher Elemente referenziert ist, von der Spitze einer theoretischen Temperaturverteilungskurve durchzuführen, die der Verteilung der repräsentativen Werte der Temperatur, die von dem Netzwerk empfindlicher Elemente gemessen wurden, am besten entspricht.

8. Messverfahren der relativen Ausrichtung zweier ebener, Seite an Seite zusammengefügter und verbundener Strukturen, das durch die folgenden Vorgänge gekennzeichnet ist:

   - Aktivierung eines Heizelements (ECH), das an einer bekannten Position auf der Oberfläche einer ersten Struktur (S1) platziert ist,
   - Erzeugung elektronischer Signale, die für eine Temperaturverteilung repräsentativ sind, ausgehend von einem Netzwerk temperaturempfindlicher Elemente (ES), die an bekannten Positionen auf der Oberfläche der zweiten Struktur (S2) platziert sind,
   - Bestimmung einer relativen Position des Heizelements im Verhältnis zum Netzwerk empfindlicher Elemente ausgehend von der Temperaturverteilung in einem Rechenkreis, der die elektronischen Signale empfängt, die in dem Netzwerk empfindlicher Elemente erzeugt werden.

9. Verfahren nach Anspruch 8, **dadurch gekennzeichnet, dass** die Bestimmung der relativen Position die Berechnung der Position, die im Verhältnis zum Netzwerk empfindlicher Elemente referenziert ist, einer Spitze einer theoretischen Temperaturverteilungskurve aufweist, die optimal einer Temperaturverteilung entspricht, die ausgehend von elektronischen, für die Temperatur repräsentativen Signalen ermittelt wurde.

10. Verfahren nach Anspruch 9, **dadurch gekennzeichnet**, das die Positionsberechnung die Berechnung mehrerer theoretischer Kurven in Abhängigkeit eines Parameters $x_0$ aufweist, der eine mögliche Position des Heizelements im Verhältnis zum Netzwerk empfindlicher Elemente ist, eine eventuell gewichtete Summenbestimmung von Abstandsquadraten zwischen den Werten der theoretischen Kurve und den gemessenen Werten, eine Auswahl der Kurve, die den niedrigsten Wert der Quadratsumme ergibt, wobei der Wert $x_{opt}$ des Parameters $x_0$, der dieser Kurve entspricht, der gesuchte Ausrichtungsmesswert ist.

**Fig. 1**

**Fig. 2**

EP 2 157 402 B1

Fig. 4

Fig. 3

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S.E. STEEN et al.** Overlay as the key to drive wafer-scale 3D intégration. *Microelectronic Engineering,* 2007, vol. 84, 1412-1415

- **A. PETROPOULOS et al.** A novel system for displacement sensing, integrated on a plastic substrate. *Microelectronics Journal,* 09 Juin 2008, vol. 40 (9), 1387-1392